# EUROPEAN PATENT APPLICATION

(11) **EP 4 685 852 A1**
(43) Date of publication of application: **28.01.2026**
(21) Application number: 24825114.2
(22) Date of filing: 28.05.2024
(51) Int. Cl.: H01L 27/12

(54) **DISPLAY SUBSTRATE AND DISPLAY APPARATUS**

(30) Priority: 21.06.2023 CN 202310744954
(71) Applicant: BOE Technology Group Co., Ltd., Beijing 100015 (CN); Wuhan Boe Optoelectronics Technology Co., Ltd., Wuhan, Hubei 430040 (CN); Beijing BOE Technology Development Co., Ltd., Daxing District Beijing 100176 (CN)
(72) Inventor: CHEN, Xiaoxiao, Beijing 100176 (CN); ZHU, Ning, Beijing 100176 (CN); LI, Yun, Beijing 100176 (CN); WANG, Chao, Beijing 100176 (CN); ZHOU, Yan, Beijing 100176 (CN); ZHANG, Yi, Beijing 100176 (CN); JIANG, Peng, Beijing 100176 (CN); LIU, Jiantao, Beijing 100176 (CN); YANG, Yue, Beijing 100176 (CN)
(74) Representative: Brötz, Helmut
(86) International application number: PCT/CN2024/095664
(87) International publication number: WO 2024/260218

(57) **Abstract**

A display substrate and a display apparatus. The display substrate comprises a base substrate (01), data lines (100), gate lines (200), a semiconductor layer (300), and transistors (400). The semiconductor layer (300) and the gate lines (200) are stacked, and the semiconductor layer (300) is located between a film layer where the gate lines (200) are located and a film layer where the data lines (100) are located. Each transistor (400) comprises a gate electrode (403), an active layer (404), a first electrode (401) and a second electrode (402), the gate electrode (403) is electrically connected to a corresponding gate line (200), the first electrode (401) is electrically connected to a corresponding data line (100), and the semiconductor layer (300) comprises the active layer. The gate lines (200) are located on the side of the data lines (100) distant from the base substrate (01), the gate electrodes (403) are arranged on the same layer as the data lines (100), the semiconductor layer (300) comprises semiconductor portions (310) on which the gate lines (200) are stacked, and the semiconductor portions (310) are spaced apart from the active layers (404). The display substrate further comprises light-shielding portions (500) arranged on the same layer as the data lines (100), and in the direction perpendicular to the base substrate (01), at least some of the semiconductor portions (310) overlap with the light-shielding portions (500) so that at least some of the semiconductor portions (310) on which the gate lines (200) are stacked are shielded by means of the light-shielding portions (500) arranged on the same layer as the data lines (100), thereby facilitating elimination of horizontal stripe defects.

## Description

This application claims priority to Chinese Patent Application No. 2023107449542, filed on June 21, 2023, the content of which is hereby incorporated by reference in its entirety as part of this application.

### TECHNICAL FIELD

Embodiments of the present disclosure relate to a display substrate and a display apparatus.

### BACKGROUND

Liquid crystal display panels have display modes such as ADS (Advanced Super Dimension Switching) and HADS (High Advanced-Super Dimensional Switching). The ADS display model is limited by the pixel structure, and the dark field area at the position of the data line has a great width, which affects the transmittance of the display panels. The display panels using the ADS display mode are often applied to large-size display products, such as television (TV) products. In the HADS display mode, the dark field area at the position of the data line has a small width, and the transmittance of the display panels is higher. The display panels using the HADS display model are often applied to small and medium-sized display products. However, in the display panels using the HADS display mode, because common electrodes cover data lines, it is a great challenge to the charging rate when the display panels using the HADS display mode are applied to large-sized display products. In order to reduce the load, an organic film (ORG) process can be used, but the process is more complex.

### SUMMARY

Embodiments of the present disclosure provide a display substrate and a display apparatus.

An embodiment of the present disclosure provides a display substrate, which includes: a base substrate, and a plurality of data lines, a plurality of gate lines, a semiconductor layer, and a plurality of transistors located on the base substrate. The plurality of data lines are arranged along a first direction; the plurality of gate lines are arranged along a second direction, the second direction intersects the first direction; the semiconductor layer is laminated with a film layer where the plurality of gate lines are located, and located between the film layer where the plurality of gate lines are located and a film layer where the plurality of data lines are located; each transistor of the plurality of transistors includes a gate electrode, an active layer, a first electrode, and a second electrode, the gate electrode is electrically connected to a gate line of the plurality of gate lines, the first electrode is electrically connected to a data line of the plurality of data lines, the semiconductor layer includes the active layer, and in a direction perpendicular to the base substrate, the gate electrode, the first electrode, and the second electrode all overlap with the active layer. The plurality of gate lines are located on a side of the plurality of data lines that is away from the base substrate, the gate electrode is disposed in the same layer as the plurality of data lines, the semiconductor layer includes a semiconductor portion laminated with the plurality of gate lines, and the semiconductor portion is spaced apart from the active layer, and the display substrate further includes a light shielding portion, disposed in the same layer as the plurality of data lines, and in the direction perpendicular to the base substrate, at least a part of the semiconductor portion is overlapped with the light shielding portion.

For example, according to an embodiment of the present disclosure, at least one gate line includes a protruding portion and a gate line main body connected to each other, a straight line extending in the first direction passes through orthographic projections of the gate electrode and the protruding portion on the base substrate, the semiconductor portion includes a first semiconductor portion laminated with the protruding portion and a second semiconductor portion laminated with the gate line main body, and more than 80% of an area of an orthographic projection of the first semiconductor portion on the base substrate falls within an orthographic projection of the light shielding portion on the base substrate.

For example, according to an embodiment of the present disclosure, at least a part of an edge of the light shielding portion is further away from the second semiconductor portion than an edge of the first semiconductor portion, and the orthographic projection of the first semiconductor portion on the base substrate is located completely within orthographic projections of the light shielding portion and gate electrode on the base substrate.

For example, according to an embodiment of the present disclosure, in the direction perpendicular to the base substrate, a part of the second semiconductor portion is overlapped with the light shielding portion.

For example, according to an embodiment of the present disclosure, more than 70% of an area of an orthographic projection, on the base substrate, of the second semiconductor portion that is laminated with a portion, of the at least one gate line, located between two adjacent data lines falls within the orthographic projection of the light shielding portion on the base substrate.

For example, according to an embodiment of the present disclosure, a plurality of light shielding portions are provided, and at least one light shielding portion and the gate electrode of at least one transistor are of an integrated structure.

For example, according to an embodiment of the present disclosure, a dimension of an overlap between the integrated structure and the gate line main body in the first direction is greater than a dimension of an overlap between the integrated structure and the protruding portion in the first direction.

For example, according to an embodiment of the present disclosure, a plurality of light shielding portions are provided, at least one light shielding portion is spaced apart from the gate electrode of any transistor, and the light shielding portion is insulated from the gate line.

For example, according to an embodiment of the present disclosure, a spacing is provided between the light shielding portion and the gate electrode nearest to the light shielding portion, and in the direction perpendicular to the base substrate, at least a part of the spacing is overlapped with the protruding portion.

For example, according to an embodiment of the present disclosure, a spacing is provided between the at least one light shielding portion and the gate electrode nearest to the light shielding portion, a portion of the gate electrode that is away from the gate line main body electrically connected to the gate electrode protrudes toward the light shielding portion, and the gate electrode and a corresponding light shielding portion are complementary in shape.

For example, according to an embodiment of the present disclosure, the light shielding portion includes a first light shielding portion overlapped with the first semiconductor portion and a second light shielding portion overlapped with the second semiconductor portion, and an edge of the second light shielding portion is closer to a data line of the plurality of data lines relative to an edge of the first light shielding portion.

For example, according to an embodiment of the present disclosure, in the direction perpendicular to the base substrate, the gate line main body is not overlapped with the gate electrode, and the gate electrode is electrically connected to the protruding portion.

For example, according to an embodiment of the present disclosure, a distance between the light shielding portion and a data line nearest to the light shielding portion is in a range from 2 to 15 micrometers.

For example, according to an embodiment of the present disclosure, a distance between the light shielding portion and the gate electrode nearest to the light shielding portion is in a range from 2 to 15 micrometers.

For example, according to an embodiment of the present disclosure, a dimension of a part of the light shielding portion that extends beyond an edge of the semiconductor portion overlapped therewith is greater than 1.65 micrometers and less than 5 micrometers.

For example, according to an embodiment of the present disclosure, the film layer where the plurality of gate lines are located is in direct contact with the semiconductor layer.

For example, according to an embodiment of the present disclosure, the display substrate further includes: a first electrode layer located between the plurality of data lines and the base substrate, and a second electrode layer located on a side of the plurality of gate lines that is away from the data lines. The first electrode layer includes a pixel electrode, the pixel electrode is electrically connected to the second electrode of the transistor, the second electrode layer includes a common electrode, the first electrode layer further includes a conductive portion, at least a part of the conductive portion is laminated with and in direct contact with the plurality of data lines, the second electrode layer further includes a plurality of connecting portions, and the gate electrode is electrically connected to the protruding portion through at least one connecting portion.

Another embodiment of the present disclosure provides a display apparatus, which includes any display substrate as mentioned above.

For example, according to an embodiment of the present disclosure, the display apparatus further includes: a backlight, located on a light incident side of the display substrate. The backlight includes a pulse width modulation backlight.

### BRIEF DESCRIPTION OF DRAWINGS

In order to clearly illustrate the technical solution of the embodiments of the present disclosure, the drawings of the embodiments will be briefly described in the following; it is obvious that the described drawings are only related to some embodiments of the present disclosure and thus are not limitative of the present disclosure.
Fig. 1 is a schematic diagram of a partial planar structure of a display substrate.
Fig. 2 is a schematic diagram of a partial cross-sectional structure cut along line AA' shown in Fig. 1.
Figs. 3A to 3C are process flow diagrams of forming the display substrate shown in Fig. 1.
Fig. 4 is a schematic diagram of a partial planar structure of a display substrate according to an embodiment of the present disclosure.
Fig. 5 is an enlarged view of a partial structure of the display substrate shown in Fig. 4.
Fig. 6 is a lamination view of a film layer where data lines are located and a film layer where pixel electrodes are located in the display substrate shown in Fig. 5.
Fig. 7 is a lamination view of the film layer where the data lines are located, the film layer where the pixel electrodes are located, a semiconductor layer, and a film layer where gate lines are located in the display substrate shown in Fig. 5.
Fig. 8 is an enlarged view of a partial structure of the display substrate shown in Fig. 5.
Fig. 9 is a schematic diagram of a partial cross-sectional structure cut along line BB' in the display substrate shown in Fig. 8.
Fig. 10 is a schematic diagram of a partial cross-sectional structure cut along line CC' in the display substrate shown in Fig. 8.
Fig. 11 is a lamination view of a film layer where data lines are located and a film layer where pixel electrodes are located in the display substrate shown in Fig. 8.
Fig. 12 is a lamination view of a semiconductor layer and a film layer where gate lines is located in the display substrate shown in Fig. 8.
Fig. 13 is a lamination view of the film layer where the data lines are located, the film layer where the pixel electrodes are located, the semiconductor layer, and the film layer where the gate lines are located in the display substrate shown in Fig. 8.
Fig. 14 is a schematic diagram of a partial planar structure of a display substrate provided in another example according to an embodiment of the present disclosure.
Fig. 15 is a schematic diagram of a partial structure of the display substrate shown in Fig. 14.
Fig. 16 is a schematic diagram of a partial cross-sectional structure cut along line DD' in the display substrate shown in Fig. 15.
Fig. 17 is a lamination view of a film layer where data lines are located and a film layer where pixel electrodes are located in the display substrate shown in Fig. 15.
Fig. 18 is a lamination view of the film layer where the data lines are located, the film layer where the pixel electrodes are located, a semiconductor layer, and a film layer where gate lines are located in the display substrate shown in Fig. 15.
Fig. 19 is a schematic diagram of a partial structure of a display apparatus according to an embodiment of the present disclosure.

### DETAILED DESCRIPTION

In order to make objects, technical details and advantages of the embodiments of the present disclosure apparent, the technical solutions of the embodiment will be described in a clearly and fully understandable way in connection with the drawings related to the embodiments of the present disclosure. It is obvious that the described embodiments are just a part but not all of the embodiments of the present disclosure. Based on the described embodiments herein, those skilled in the art can obtain other embodiment(s), without any inventive work, which should be within the scope of the present disclosure.

Unless otherwise defined, all the technical and scientific terms used herein have the same meanings as commonly understood by one of ordinary skill in the art to which the present disclosure belongs. The terms "first," "second," etc., which are used in the present application for disclosure, are not intended to indicate any sequence, amount or importance, but distinguish various components. The terms "comprise," "comprising," "include," "including," etc., are intended to specify that the elements or the objects stated before these terms encompass the elements or the objects and equivalents thereof listed after these terms, but do not preclude the other elements or objects. The features "parallel", "perpendicular" and "same" used in the embodiments of the present disclosure all include features such as "parallel", "perpendicular" and "same" in the strict sense, and the cases having certain errors, such as "approximately parallel", "approximately perpendicular", "approximately the same" or the like, taking into account measurements and errors associated with the measurement of a particular quantity (e.g., limitations of the measurement system), and indicate being within an acceptable range of deviation for a particular value as determined by one of ordinary skill in the art. For example, "approximately" may indicate being within one or more standard deviations, or within 10% or 5% of the stated value. In the case that the quantity of a component is not specifically indicated below in the embodiments of the present disclosure, it means that the component may be one or more, or may be understood as at least one. "At least one" means one or more, and "plurality" means at least two. The "same layer " in the present disclosure refers to the structure formed by two (or more) structures formed by the same deposition process and patterned by the same patterning process, and their materials may be the same or different.

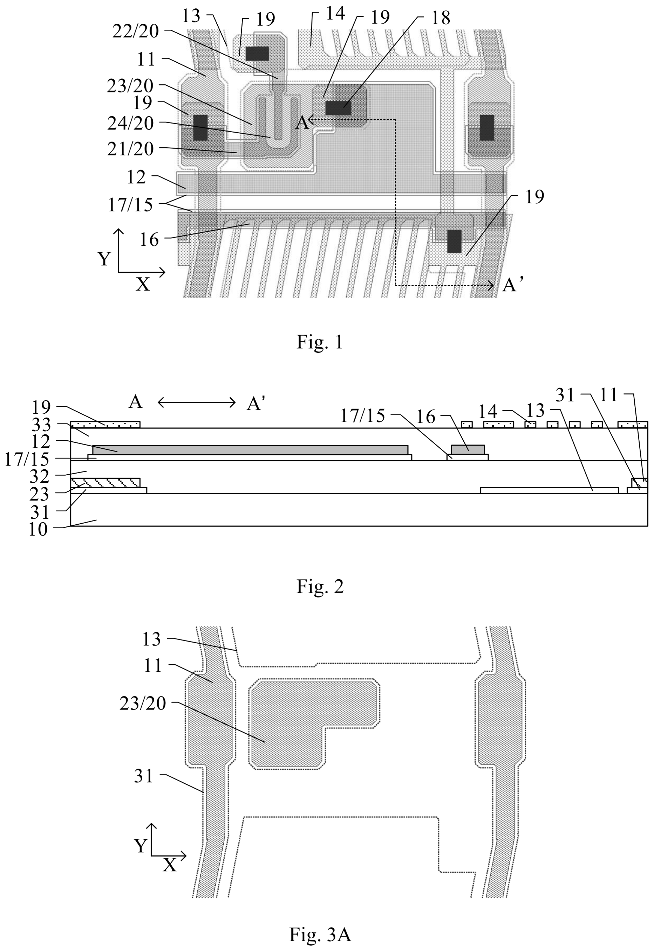

Fig. 1 is a schematic diagram of a partial planar structure of a display substrate. Fig. 2 is a schematic diagram of a partial cross-sectional structure cut along line AA' shown in Fig. 1. As shown in Figs. 1 and 2, the display substrate may be in an HADS display mode. The display substrate includes a base substrate 10 and a plurality of data lines 11 and a plurality of gate lines 12 on the base substrate 10. The plurality of data lines 11 and the plurality of gate lines 12 are insulated from and cross each other to define a plurality of sub-pixels. Each sub-pixel includes a pixel electrode 13, a common electrode 14, and a transistor 20. The transistor 20 includes a first electrode 21, a second electrode 22, and a gate electrode 23. The gate line 12 is electrically connected to the gate electrode 23 of the transistor 20 to control the on or off of the transistor 20. The pixel electrode 13 is electrically connected to the second electrode 22 of the transistor 20. The data line 11 is electrically connected to the first electrode 21 of the transistor 20. The data line 11 inputs a voltage signal required for image display to the pixel electrode 13 of the sub-pixel through the transistor 20 to realize the display of the display apparatus including the display substrate.

As shown in Fig. 1, the display substrate further includes a semiconductor layer 15, the semiconductor layer 15 is laminated with a film layer where the gate lines 12 are located, and the semiconductor layer 15 is located between the film layer where the gate lines 12 are located and the base substrate 10.

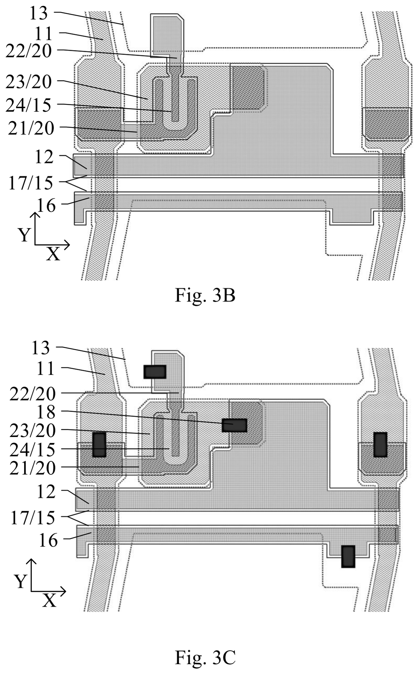

Figs. 3A to 3C are process flow diagrams of forming the display substrate shown in Fig. 1. As shown in Figs. 2 and 3A, the data line 11, the pixel electrode 13, and the gate electrode 23 of the transistor 20 are formed by a Half-Tone-Mask patterning process. A conductive layer 31 disposed in the same layer as the pixel electrode 13 is formed between the data line 11 and the base substrate 10. As shown in Figs. 2 and 3B, the gate line 12, a common electrode line 16, the first electrode 21 and the second electrode 22 of the transistor 20 are formed through the Half-Tone-Mask patterning process. The semiconductor layer 15 is formed between the gate line 12, the common electrode line 16, the first electrode 21 and the second electrode 22 of the transistor 20 and the base substrate 10. The semiconductor layer 15 includes an active layer 24 laminated with the first electrode 21 and the second electrode 22 of the transistor 20 and a semiconductor lamination portion 17 laminated with the gate line 12 and the common electrode line 16. As shown in Figs. 1, 2, and 3C, via holes 18 are formed in an insulating layer on a side of the gate line 12 that is away from the base substrate 10 and an insulating layer on a side of the data line 11 that is away from the base substrate 10; a film layer where the common electrode 14 is located is formed on a side of the insulating layer away from the base substrate. For example, the display substrate further includes a plurality of connecting portions 19 disposed in the same layer as the common electrode 14.

As shown in Fig. 1, the first electrode 21 of the transistor 20 is electrically connected to the data line 11 through a corresponding connecting portion 19, the second electrode 22 of the transistor 20 is electrically connected to the pixel electrode 13 through a corresponding connecting portion 19, the gate electrode 23 of the transistor 20 is electrically connected to the gate line 12 through a corresponding connecting portion 19, and a common electrode line 16 is electrically connected to the common electrode 14 through a corresponding connecting portion 19. For example, the connecting portion 19 connected to the common electrode line 16 and the common electrode 14 may be of an integrated structure.

As shown in Fig. 2, the display substrate further includes an insulating layer 32 and an insulating layer 33, the insulating layer 32 is located between the semiconductor layer 15 and the film layer where the data line 11 is located, and the insulating layer 33 is located between the film layer where the common electrode 14 is located and the film layer where the gate line 12 is located.

In process steps shown in Fig. 3B, while the gate line and the semiconductor lamination portion are formed, an edge of the semiconductor lamination portion protrudes outward relative to an edge of the gate line. For example, the area of the semiconductor lamination portion is greater than the area of the gate line, and the edge of the semiconductor lamination portion is closer to the common electrode, and/or, the edge of the semiconductor lamination portion is closer to the pixel electrode, such that the coupling capacitance between the gate line which is in direct contact with the semiconductor lamination portion and the common electrode, and/or, the coupling capacitance between the gate line and the pixel electrode is greater.

The display substrate is applied to a liquid crystal display apparatus which includes a backlight located on a side of the semiconductor lamination portion that is away from the gate line. Because no light shield layer is provided between the semiconductor lamination portion and the backlight, light from the backlight directed to the display substrate directly irradiates the semiconductor lamination portion. As an example, the backlight may be pulse width modulation (PWM) backlight, there is a difference between the on state and the off state of the backlight, so there is a difference in conduction state of the semiconductor lamination portion before and after it is illuminated. The difference is directly reflected in the delay of a signal transmitted by the gate line, i.e., the falling edge time Tf of a gate signal is different. In the design of the display substrate, gate output enable (GOE) is fixed; when the backlight is in different states of on and off, the gate line signal enable time is different, and the charging duration of sub-pixels is different, which will make the sub-pixels have bright and dark differences, and thus resulting in the risk of horizontal stripe defects (unevenness).

The present disclosure provides a display substrate and a display apparatus. The display substrate includes a base substrate, and a plurality of data lines, a plurality of gate lines, a semiconductor layer, and a plurality of transistors disposed on the base substrate. The plurality of data lines are arranged in a first direction; the plurality of gate lines are arranged in a second direction, with the second direction intersecting the first direction; the semiconductor layer is laminated with a film layer where the gate lines are located, and is located between the film layer where the gate lines are located and the film layer where the data lines are located; each of the transistors includes a gate electrode, an active layer, a first electrode, and a second electrode, the gate electrode is electrically connected to the gate line, the first electrode is electrically connected to the data line, the semiconductor layer includes the active layer, and in a direction perpendicular to the base substrate, the gate electrode, the first electrode, and the second electrode all overlap with the active layer. The plurality of gate lines are located on the side of the plurality of data lines that is away from the base substrate, the gate electrodes are disposed in the same layer as the data lines, the semiconductor layer includes a semiconductor portion laminated with the gate lines, and the semiconductor portion is spaced apart from the active layer. The display substrate further includes a light shielding portion, disposed in the same layer as the data lines, and in the direction perpendicular to the base substrate, at least a part of the semiconductor portion is overlapped with the light shielding portion. In the display substrate provided in the present disclosure, the gate lines are disposed on the side of the data lines that is away from the base substrate while the at least a part of the semiconductor portion that is laminated with the data lines is shaded by the light shielding portion disposed in the same layer as the data lines, so that the effect of the switching of the backlight on the capacitance of the gate lines is reduced to lower the impact on the falling edge time of the gate signal transmitted on the gate lines, thus eliminating the horizontal stripe defects.

The display substrate and display apparatus provided in the embodiments of the present disclosure are described below with reference to the accompanying drawings.

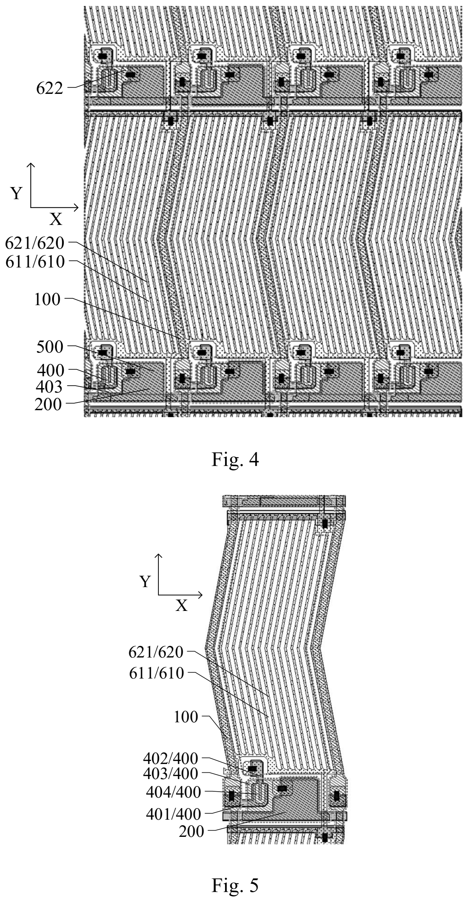

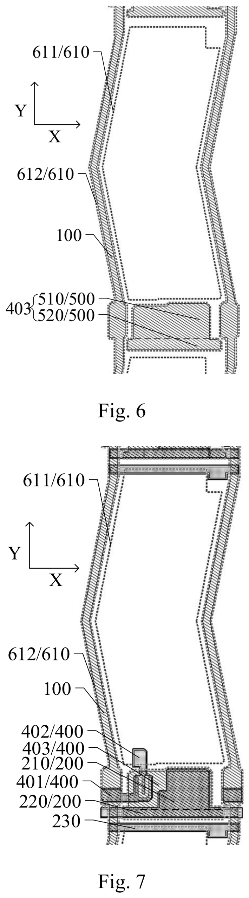

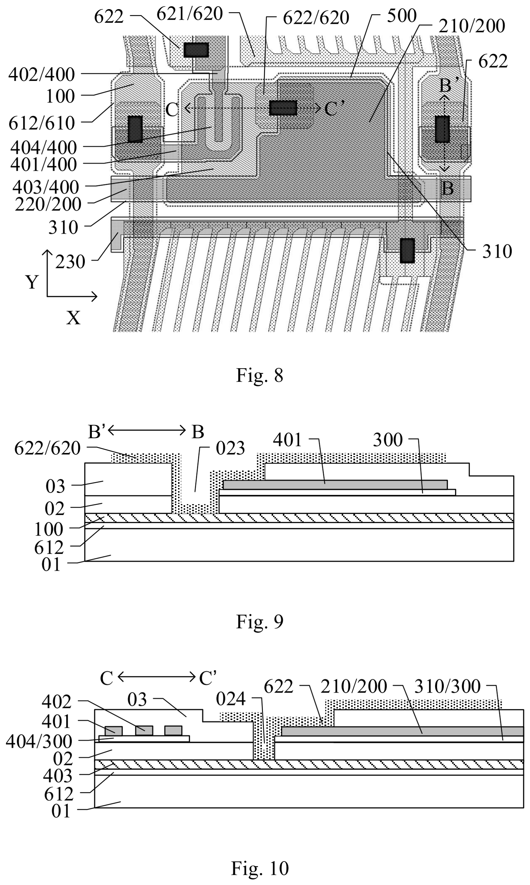

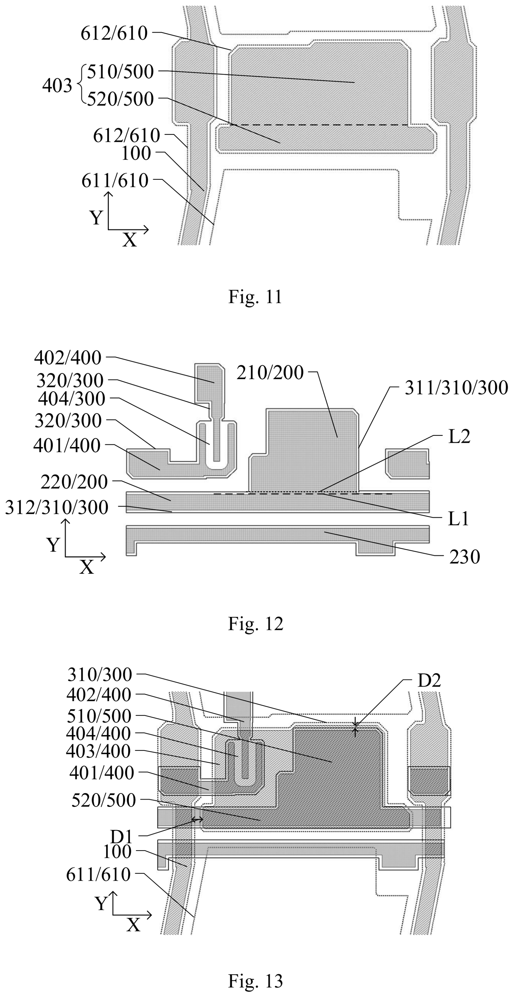

Fig. 4 is a schematic diagram of a partial planar structure of a display substrate according to an embodiment of the present disclosure. Fig. 5 is an enlarged view of a partial structure of the display substrate shown in Fig. 4. Fig. 6 is a lamination view of a film layer where data lines are located and a film layer where pixel electrodes are located in the display substrate shown in Fig. 5. Fig. 7 is a lamination view of the film layer where the data lines are located, the film layer where the pixel electrodes are located, a semiconductor layer, and a film layer where gate lines are located in the display substrate shown in Fig. 5. Fig. 8 is an enlarged view of a partial structure of the display substrate shown in Fig. 5. Fig. 9 is a schematic diagram of a partial cross-sectional structure cut along line BB' in the display substrate shown in Fig. 8. Fig. 10 is a schematic diagram of a partial cross-sectional structure cut along line CC' in the display substrate shown in Fig. 8. Fig. 11 is a lamination view of a film layer where data lines are located and a film layer where pixel electrodes are located in the display substrate shown in Fig. 8. Fig. 12 is a lamination view of a semiconductor layer and a film layer where gate lines is located in the display substrate shown in Fig. 8. Fig. 13 is a lamination view of the film layer where the data lines are located, the film layer where the pixel electrodes are located, the semiconductor layer, and the film layer where the gate lines are located in the display substrate shown in Fig. 8.

As shown in Figs. 4, 8, 9, and 10, the display substrate includes a base substrate 01, and a plurality of data lines 100, a plurality of gate lines 200, a semiconductor layer 300, and a plurality of transistors 400 disposed on the base substrate 01. The plurality of data lines 100 are arranged in a first direction, and the plurality of gate lines 200 are arranged in a second direction, with the first direction intersecting the second direction. Fig. 4 schematically shows the first direction as an X direction and the second direction as a Y direction. For example, the first direction and the second direction may be interchangeable. For example, the first direction is perpendicular to the second direction. For example, an included angle between the first direction and the second direction may be 80 to 100 degrees.

For example, as shown in Fig. 4, the plurality of data lines 100 and the plurality of gate lines 200 are insulated from and cross each other to define a plurality of pixel areas, and each of the pixel areas has one sub-pixel. Figs. 5 to 7 schematically show one pixel area.

For example, as shown in Figs. 4 and 5, one sub-pixel may include at least one transistor 400. An embodiment of the present disclosure schematically shows one sub-pixel including a single transistor 400. However, it is not limited thereto, the sub-pixel may include two or more transistors. For example, the display substrate includes a plurality of sub-pixels. For example, the plurality of sub-pixels are arranged in an array in the first direction and the second direction.

As shown in Fig. 4 and Figs. 8 to 13, the semiconductor layer 300 is laminated with the film layer where the gate lines 200 are located, and is located between the film layer where the gate lines 200 are located and the film layer where the data lines 100 are located; each of the transistors 400 includes a gate electrode 403, an active layer 404, a first electrode 401, and a second electrode 402, and the gate electrode 403 is electrically connected to the gate line 200, and the first electrode 401 is electrically connected to the data line 100. The semiconductor layer 300 includes an active layer 404, and in a direction perpendicular to the base substrate 01, the gate electrode 403, the first electrode 401, and the second electrode 402 are all overlapped with the active layer 404. For example, in the case that the display substrate is applied to a liquid crystal display apparatus, the liquid crystal display apparatus includes a backlight, such as a pulse width modulation (PWM) backlight, the gate electrode 403 is located between the active layer 404 and the backlight, and the gate electrode 403 may shield the active layer 404 to prevent light emitted from the backlight from irradiating the active layer 404. For example, the gate line 200 controls the on or off of the transistor 400, and the data line 100 inputs a voltage signal required for image display to the pixel electrode 611 (described subsequently) of the sub-pixel through the transistor 400 to realize the display of the display apparatus including the display substrate.

For example, one of the first electrode 401 and the second electrode 402 of the transistor 400 is a source electrode and the other is a drain electrode. For example, the transistor 400 may be a thin-film transistor or a field-effect transistor or other switching device having the same characteristics. The source and drain electrodes of the transistor employed herein may be structurally symmetrical, so that the source and drain electrodes may be structurally indistinguishable. In an embodiment of the present disclosure, in order to distinguish the two electrodes of the transistor other than the gate electrode, one of the two electrodes is directly described as the first electrode and the other one as the second electrode, so that the first electrode and the second electrode of all or some of the transistors in the embodiments of the present disclosure are interchangeable as needed. For example, the first electrode of the transistor described in the embodiment of the present disclosure may be a source electrode and the second electrode may be a drain electrode; alternatively, the first electrode of the transistor may be a drain electrode and the second electrode may be a source electrode. In addition, the transistors may be divided into N-type transistors and P-type transistors according to characteristics thereof. The transistors provided in the embodiments of the present disclosure may be the N-type transistors or the P-type transistors according to actual needs.

As shown in Fig. 4 and Figs. 8 to 13, the plurality of gate lines 200 are disposed on the side of the plurality of data lines 100 that is away from the base substrate 01, the gate electrode 403 is disposed in the same layer as the data lines 100, and the semiconductor layer 300 includes a semiconductor portion 310 that is laminated with the gate lines 200, and the semiconductor portion 310 and the active layer 404 are spaced apart from each other. For example, in the direction perpendicular to the base substrate 01, the active layer 404 is not overlapped with the gate lines 200, and the semiconductor portion 310 is not overlapped with both the first electrode 401 and the second electrode 402 of the transistor 400. For example, the active layer 404 is insulated from the semiconductor portion 310.

Generally, in the display substrate using the HADS display mode, an organic insulating layer is provided between the data line and an electrode (ITO) on a side of the data line that is away from the base substrate for increasing a distance between the data line and the electrode. However, as compared with the display substrate using the ADS display mode, a process of preparing the organic insulating layer is added for the display substrate using the HADS display mode, which increases the process complexity.

As compared to the display apparatus using the HADS display mode, the display substrate of the present disclosure has the advantages that, the film layers of the data lines and the gate lines in the display substrate are interchanged, which may not only allow the data lines and electrodes, e.g., the common electrodes (described subsequently), to still have a large distance to reduce the coupling capacitance of the two and to reduce the load of the data lines, but also maintain the same preparation process as that of the display substrate using the ADS display mode so as to achieve the same process complexity and to increase the transmittance of the display substrate.

As shown in Figs. 4 and 8, and Figs. 11 to 13, the display substrate further includes a light shielding portion 500, where the light shielding portion 500 is disposed in the same layer as the data lines 100, and in the direction perpendicular to the base substrate 01, at least a part of the semiconductor portion 310 is overlapped with the light shielding portion 500. For example, the light shielding portion 500 and the gate electrode 403 are disposed in the same layer.

In the display substrate provided in the present disclosure, the gate lines are disposed on the side of the data lines that is away from the base substrate while the at least a part of the semiconductor portion that is laminated with the gate lines is shaded by the light shielding portion disposed in the same layer as the data lines, so that the effect of the switching of the backlight on the capacitance of the gate lines is reduced to lower the impact on the falling edge time of the gate signal transmitted on the gate lines, thus eliminating the horizontal stripe defects.

As compared to the display substrate shown in Fig. 1, the display substrate provided in the present disclosure has the advantages that by providing the light shielding portion between the semiconductor portion laminated with the gate lines and the backlight to effectively shield the backlight from direct irradiating the semiconductor portion, the risk of horizontal stripe defect is eliminated.

In some examples, as shown in Fig. 4, a plurality of light shielding portions 500 are provided, and at least one light shielding portion 500 and the gate electrode 403 of the at least one transistor 400 are of an integrated structure. For example, the gate electrode 403 of the at least one transistor 400 is also used as a light shielding portion 500. For example, the gate electrode 403 of each transistor 400 is also used as the light shielding portion 500.

In some examples, as shown in Figs. 4, 8, and 12, at least one gate line 200 includes a protruding portion 210 and a gate line main body 220 connected to each other. For example, the protruding portion 210 in the gate line 200 is a portion of the gate line 200. The gate line 200 includes a linear structure extending in the X direction, i.e., the gate line main body 220, and the protruding portion 210 connected to the linear structure. The protruding portion 210 is a portion protruding toward the second electrode 402 of the transistor 400 relative to the gate line main body 220. For example, the protruding portion 210 and the gate line main body 220 are of an integrated structure. For example, a boundary between the protruding portion 210 and the gate line main body 220 may be a boundary L1 shown in the figures.

For example, as shown in Figs. 4, 8, and 12, at least one gate line 200 includes a plurality of protruding portions 210 and one gate line main body 220. Each transistor 400 corresponds to one protruding portion 210, and the plurality of protruding portions 210 are all located on the same side of the gate line main body 220. For example, each of the gate lines 200 includes a protruding portion 210, e.g., each of the gate lines 200 includes a plurality of protruding portions 210 and one gate line main body 220.

In some examples, as shown in Figs. 4 and 8, and Figs. 11 to 13, a straight line extending in the first direction passes through orthographic projections of the gate electrode 403 and the protruding portion 210 on the base substrate. For example, at least a part of the protruding portion 210 is overlapped with the gate electrode 403 in the direction perpendicular to the base substrate 01. For example, the gate electrode 403 is electrically connected to the protruding portion 210 to realize an electrical connection with the gate line 200.

In some examples, as shown in Fig. 12, the semiconductor portion 310 includes a first semiconductor portion 311 laminated with the protruding portion 210 and a second semiconductor portion 312 laminated with the gate line main body 220. For example, the first semiconductor portion 311 and the second semiconductor portion 312 are of an integrated structure. Fig. 12 schematically shows a boundary L2 between the first semiconductor portion 311 and the second semiconductor portion 312, which is closer to the active layer 404 of the transistor 400 than the boundary L1.

For example, as shown in Fig. 12, the first semiconductor portion 311 may have a planar shape substantially the same as that of the protruding portion 210, and the area of the first semiconductor portion 311 is slightly greater than the area of the protruding portion 210. For example, the second semiconductor portion 312 may have a planar shape of strip. A length of the second semiconductor portion 312 is slightly greater than a length of the gate line main body 220, and a width of the second semiconductor portion 312 is slightly greater than a width of the gate line main body 220.

In some examples, as shown in Fig. 10, the film layer where the gate line 200 is located is in direct contact with the semiconductor layer 300.

For example, as shown in Fig. 12, the pattern of the layer where the gate line 200 is located and the pattern of the layer where the semiconductor portion 310 is located are formed using the same mask, e.g., are formed using the half-tone-mask process. The patterns of the two layers are laminated and are in direct contact with each other, and an edge of the semiconductor portion 310 protrudes outward relative to an edge of the gate line 200. As shown in Fig. 12, the edge of the semiconductor portion 310 is located on the outside of the edge of the gate line 200, for example, a protruding portion of the edge of the semiconductor portion 310 relative to the edge of the gate line 200 may be referred to as an active tail. Thus, the area of the first semiconductor portion is slightly greater than the area of the protruding portion, and the width of the second semiconductor portion is slightly greater than the width of the gate line main body.

For example, as shown in Fig. 11, the pattern of the layer where the data line 100 is located and the pattern of the layer where the pixel electrode 611 is located are formed using the same mask, e.g., formed using the half-tone-mask process, and the patterns of the two layers are laminated and in direct contact with each other.

For example, as shown in Fig. 12, an orthographic projection of the gate line 200 on the base substrate is located completely within an orthographic projection of the semiconductor portion 310 on the base substrate.

For example, as shown in Fig. 12, the semiconductor layer 300 further includes an active lamination portion 320, the active lamination portion 320 and the active layer 404 are of an integrated structure, the active lamination portion 320 is overlapped with a part of the first electrode 401 and second electrode 402 of a transistor 400, and the active layer 404 is overlap with the other part of the first electrode 401 and second electrode 402 of the transistor 400. For example, an orthographic projection of the active layer 404 on the base substrate is located completely within an orthographic projection of the gate electrode 403 on the base substrate, and the active lamination portion 320 overlaps with the data line 100 and the pixel electrode 611 (described subsequently). For example, orthographic projections of the first electrode 401 and the second electrode 402 of the transistor 400 on the base substrate are located completely within an orthographic projection of the integrated structure of the active lamination portion 320 and the active layer 404 on the base substrate. For example, the semiconductor layer 300 overlapped with the first electrode 401 of the transistor 400 and the semiconductor layer 300 overlapped with the second electrode 402 of the transistor 400 are of an integrated structure.

In some examples, as shown in Figs. 12 to 14, more than 80% of the area of an orthographic projection of the first semiconductor portion 311 on the base substrate falls within an orthographic projection of the light shielding portion 500 on the base substrate.

As compared to the display substrate shown in Fig. 1, the display substrate provided in the present disclosure has the advantages that since the light shielding portion is located between the first semiconductor portion and the backlight and more than 80% of the first semiconductor portion is covered with the light shielding portion, the backlight is effectively shielded from directly irradiating the semiconductor portion, which is conductive to lowering the risk of horizontal stripe defects.

For example, as shown in Figs. 12 to 13, more than 85% of the area of the orthographic projection of the first semiconductor portion 311 on the base substrate falls within the orthographic projection of the light shielding portion 500 (or the gate electrode 403) on the base substrate. For example, more than 90% of the area of the orthographic projection of the first semiconductor portion 311 on the base substrate falls within the orthographic projection of the light shielding portion 500 (or the gate electrode 403) on the base substrate. For example, more than 95% of the area of the orthographic projection of the first semiconductor portion 311 on the base substrate falls within the orthographic projection of the light shielding portion 500 (or the gate electrode 403) on the base substrate. For example, the orthographic projection of the first semiconductor portion 311 on the base substrate falls completely within the orthographic projection of the light shielding portion 500 (or the gate electrode 403) on the base substrate.

In the display substrate provided in the present disclosure, by setting the light shielding portion and the gate electrode of the transistor into an integrated structure, the first semiconductor portion can be shaded as much as possible, e.g., can be covered fully, to more effectively reduce direct irradiation of the backlight to the first semiconductor portion, thus further lowering the risk of horizontal stripe defects.

In some examples, as shown in Fig. 8 and Figs. 11 to 13, a part of the second semiconductor portion 312 is overlapped with the light shielding portion 500 in the direction perpendicular to the base substrate (e.g., a direction perpendicular to the XY plane). For example, a plurality of light shielding portions 500 are provided. In the direction perpendicular to the base substrate, the second semiconductor portion 312 includes a first part overlapped with the light shielding portions 500 and a second part overlapped with the data lines 100. The first parts and the second parts are arranged in the X direction alternatively. For example, the part of the light shielding portions 500 located between two adjacent data lines 100 that is overlapped with the second semiconductor portion 312 may have the same or different distance with the two adjacent data lines 100.

The light shielding portion shades the second semiconductor portion of the semiconductor layer that is overlapped with the gate line main body, which is conductive to further reducing the affect from the irradiated semiconductor layer to the signal of the gate line.

In some examples, as shown in Figs. 8 and 13, more than 70% of the area of the orthographic projection, on the base substrate, of the second semiconductor portion 312 that is laminated with a portion of the at least one gate line 200 located between two adjacent data lines 100 falls within the orthographic projection of the light shielding portion 500 on the base substrate. For example, in the case that one second semiconductor portion 312 is overlapped with one gate line 200, more than 70% of the area of the orthographic projection, on the base substrate, of a portion of the at least one second semiconductor portion 312 located between the two adjacent data lines 100 falls within the orthographic projection of the light shielding portion 500 on the base substrate. For example, more than 70% of the area of the orthographic projection, on the base substrate 01, of a portion that is of the at least one second semiconductor portion 312 and that is other than the portion overlapped with the data line 100, falls within the orthographic projection of the light shielding portion 500 on the base substrate.

By arranging more than 70% of the area of the orthographic projection of the second semiconductor portion located between adjacent data lines overlapped with that of the light shielding portion, the area of the portion of the second semiconductor portion that is directly irradiated by the backlight can be greatly reduced, thus reducing the impact on the signal of the gate line after the second semiconductor portion is irradiated by light.

In some examples, as shown in Fig. 8 and Figs. 11 to 13, the integrated structure is also used as the gate electrode 403 of the light shielding portion 500 or the light shielding portion 500 of the gate electrode 403, and the dimension of an overlap between the integrated structure and the gate line main body 220 in the first direction is greater than the dimension of an overlap between the integrated structure and the protruding portion 210 in the first direction.

In some examples, as shown in Figs. 11 to 13, the dimension, in the Y direction, of a portion of the gate electrode 403 that is overlapped with the protruding portion 210 of the gate line 200 is greater than the dimension, in the Y direction, of a portion of the gate electrode 403 that is overlapped with the active layer 404 such that an edge of the gate electrode 403 protrudes out of an edge of the protruding portion 210, which is conductive to using the gate electrode that is also used as the light shielding portion to shield the semiconductor portion at the edge of the protruding portion.

In some examples, as shown in Figs. 11 to 13, at least a part of an edge of the light shielding portion 500 is further away from the second semiconductor portion 312 than an edge of the first semiconductor portion 311, and the orthographic projection of the first semiconductor portion 311 on the base substrate is located completely within the orthographic projections of the light shielding portion 500 and gate electrode 403 on the base substrate. For example, the orthographic projection of the first semiconductor portion 311 on the base substrate is located completely within the orthographic projection on the base substrate of the gate electrode 403 that is also used as the light shielding portion 500.

In some examples, as shown in Fig. 13, the part of the light shielding portion 500 that extends beyond the edge of the semiconductor portion 310 overlapped therewith has a dimension D2 greater than 1.65 micrometers and less than 5 micrometers such that the light shielding portion can still shield the semiconductor portion from the effect of the backlight after accounting for process fluctuations and fluctuations in the critical dimensional values. For example, the dimension D2 of the edge of the light shielding portion 300 beyond the edge of the semiconductor portion 310 may be 2 to 4 micrometers, or 2.5 to 4.5 micrometers, or 3 to 3.5 micrometers, and the like. For example, the dimension of the part of the light shielding portion 500 that extends beyond the edge of the first semiconductor portion 311 that is overlapped therewith may be the dimension D2 as mentioned above. For example, the dimension of the part of the light shielding portion 500 that extends beyond the edge of the second semiconductor portion 312 that is overlapped therewith may be the dimension D2 as mentioned above.

In some examples, as shown in Fig. 13, a distance D1 between the light shielding portion 500 and the data line 100 nearest to the light shielding portion 500 is in a range from 2 to 15 micrometers to enable the light shielding portion to project as far as possible toward the data line to shield the backlight from irradiating the semiconductor portion while avoiding a short circuit between the light shielding portion and the data line. For example, the distance D1 between the light shielding portion 500 and the data line 100 nearest thereto may be in a range from 4.5 to 12 micrometers. For example, the distance D1 between the light shielding portion 500 and the data line 100 nearest thereto may be in a range from 4.8 to 10 micrometers. For example, the distance D1 between the light shielding portion 500 and the data line 100 nearest thereto may be in a range from 5 to 8 micrometers. For example, the distance D1 between the light shielding portion 500 and the data line 100 nearest thereto may be in a range from 6 to 9 micrometers. For example, the distance D1 between the light shielding portion 500 and the data line 100 nearest thereto may be in a range from 5.5 to 7 micrometers.

In some examples, as shown in Figs. 11 to 13, the light shielding portion 500 includes a first light shielding portion 510 overlapped with the first semiconductor portion 311 and a second light shielding portion 520 overlapped with the second semiconductor portion 312. Edges of the second light shielding portion 520 protrude from both sides relative to edges of the first light shielding portion 510. Fig. 11 schematically shows a positional relationship between the first light shielding portion 510 and the second light shielding portion 520 when the gate electrode 403 is used as the light shielding portion 500.

For example, as shown in Figs. 8 and 11, the distance between the first light shielding portion 510 and the data line 100 on the left side thereof is less than the distance between the first light shielding portion 510 and the data line 100 on the right side thereof. As an example, a portion of a common electrode 621 extending in the Y direction is provided between the first light shielding portion 510 and the data line 100 on the right side thereof, so that the first light shielding portion effectively shields the active layer and the first semiconductor portion while the overlap area between the common electrode and the gate line is minimized, thus avoiding the short circuit between the connecting portion electrically connected to the data line and the common electrode disposed in the same layer. The direction indicated by an arrow in the X direction in the figures is to the right. For example, in the direction perpendicular to the base substrate, the protruding portion 210 is not overlapped with the common electrode 621.

In some examples, as shown in Figs. 4 to 13, the display substrate further includes a first electrode layer 610 and a second electrode layer 620 laminated with each other, the first electrode layer 610 is located between the data line 400 and the base substrate 01, and the second electrode layer 620 is disposed on a side of the gate line 200 that is away from the data lines 100. The first electrode layer 610 includes the pixel electrode 611. The pixel electrode 611 is electrically connected to the second electrode 402 of the transistor 400, the second electrode layer 620 includes the common electrode 621, the first electrode layer 610 further includes a conductive portion 612, at least a part of the conductive portion 612 is laminated with and in direct contact with the data line 100, the second electrode layer 620 further includes a plurality of connecting portions 622, the gate electrode 403 is electrically connected to the protruding portion 210 through at least one connecting portion 622. For example, both the first electrode layer 610 and the second electrode layer 620 are made of a light-transmission conductive material. For example, the material of the first electrode layer 610 and the material of the second electrode layer 620 may be the same, such as both being indium tin oxide (ITO). However, it is not limited thereto, the material of the first electrode layer and the material of the second electrode layer may be different.

For example, as shown in Figs. 5 to 7, the pixel electrode 611 may be a block electrode and the common electrode 621 may include a plurality of strip electrodes. For example, the sub-pixel including the pixel electrode 611 and the common electrode 621 may have a dual-domain structure.

For example, as shown in Figs. 6 and 11, the conductive portion 612 includes a part that is laminated with and in direct contact with the data line 100, and a part that is laminated with and in direct contact with the gate electrode 403. For example, the two parts of the conductive portion 612 that are laminated with the data line 100 and the gate electrode 403 may be spaced apart. However, it is not limited thereto, the two parts may be of an integrated structure. For example, the planar shape of the conductive portion 612 that is laminated with and in direct contact with the gate electrode 403 may be substantially the same as the planar shape of the gate electrode 403, and the area of the conductive portion 612 is slightly greater than the area of the gate electrode 403.

For example, as shown in Figs. 8 to 10, there are a plurality of connecting portions 622. Some of the plurality of connecting portions 622 are used for connecting the gate electrodes 403 and the gate lines 200, some of the plurality of connecting portions 622 are used for connecting the data lines 100 and the first electrodes 401 of the transistors 400, and some of the plurality of connecting portions 622 are used for connecting the pixel electrodes 611 and the second electrodes 402 of the transistors 400.

For example, as shown in Figs. 9 and 10, an insulating layer 02 is provided between the data line 100 and the semiconductor layer 300, an insulating layer 03 is provided between the first electrode 401 of the transistor 400 and the second electrode layer 620, a via hole 023 is provided in the insulating layer 02 and the insulating layer 03, and the connecting portion 622 is electrically connected to the data line 100 and the first electrode 401 of the transistor through the via hole 023; the insulating layer 02 and the insulating layer 03 are provided with a via hole 024, and the connecting portion 622 is electrically connected to the gate electrode 403 and the gate line 200 through the via hole 024.

For example, as shown in Fig. 9, the materials of the film layer where the data line 100 is located and the film layer where the gate line 200 is located may include copper. For example, the materials of the insulating layer 02 and the insulating layer 03 may include silicon nitride. For example, the material of the semiconductor layer 300 may include A-Si.

For example, as shown in Figs. 7, 8, and 12, the display substrate further includes a common electrode line 230 disposed in the same layer as the gate line 200. The common electrode line 230 is electrically connected to the common electrode 621. For example, the semiconductor layer 300 further includes a portion that is laminated with and in direct contact with the common electrode line 230.

In some examples, as shown in Fig. 8, in the direction perpendicular to the base substrate, the gate line main body 220 is not overlapped with the gate electrode 403, and the gate electrode 403 is electrically connected to the protruding portion 210. For example, the gate electrode 403 is electrically connected to the protruding portion 210 via the connecting portion 622.

In the display substrate provided in the present disclosure, the pixel electrodes and the data lines are schematically patterned using the same mask, and the display substrate includes the conductive portion that is laminated with and in direct contact with the data lines and the gate electrodes. However, it is not limited thereto, the pattern of the film layer where the data lines are located and the pattern of the pixel electrodes may be formed individually using different masks, at which time no conductive portion laminated therewith is provided under the data lines and the gate electrodes.

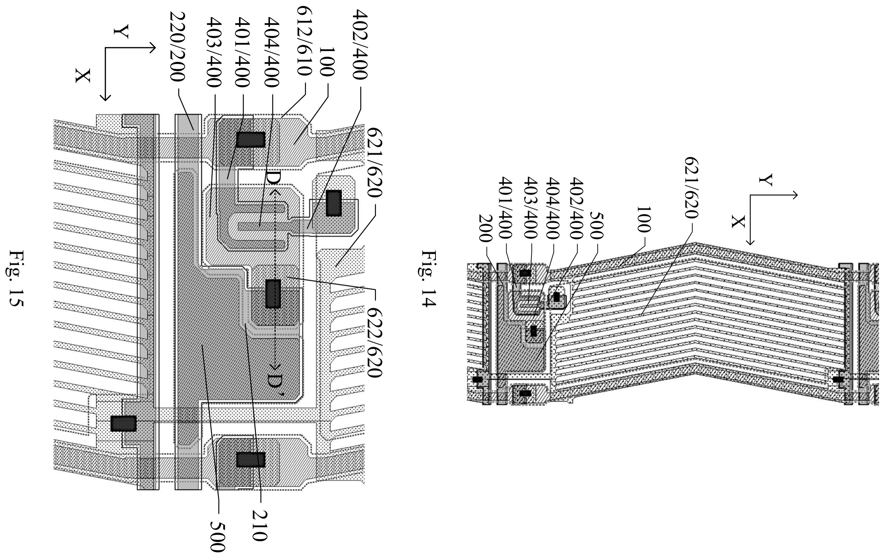

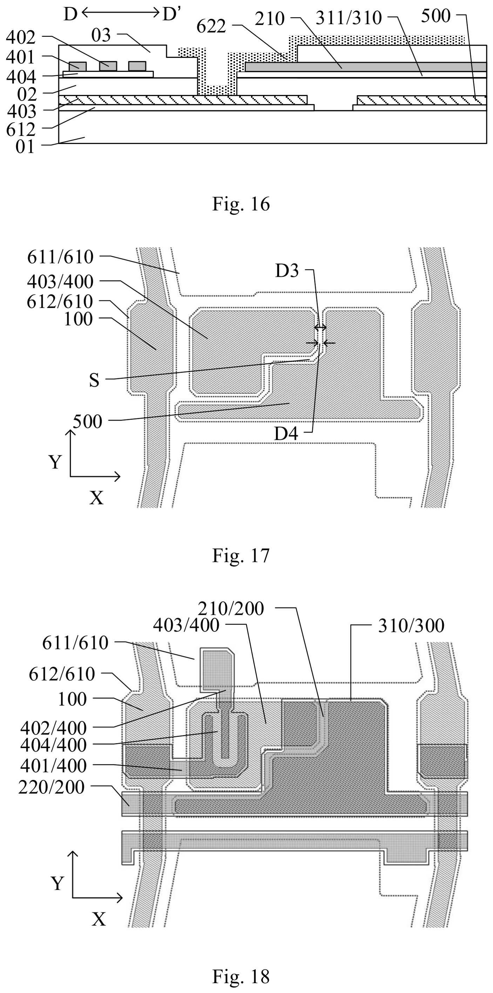

Fig. 14 is a schematic diagram of a partial planar structure of a display substrate provided in another example according to an embodiment of the present disclosure. Fig. 15 is a schematic diagram of a partial structure of the display substrate shown in Fig. 14. Fig. 16 is a schematic diagram of a partial cross-sectional structure cut along line DD' in the display substrate shown in Fig. 15. Fig. 17 is a lamination view of a film layer where data lines are located and a film layer where pixel electrodes are located in the display substrate shown in Fig. 15. Fig. 18 is a lamination view of the film layer where the data lines are located, the film layer where the pixel electrodes are located, a semiconductor layer, and a film layer where gate lines are located in the display substrate shown in Fig. 15.

The difference between the display substrate shown in Figs. 14 to 18 and the display substrate shown in Figs. 4 to 13 lies in the different shape of the light shielding portion 500. The structures such as the data line, the pixel electrode, the first electrode of the transistor, the second electrode of the transistor and the active layer of the transistor, the gate line, the semiconductor portion, the common electrode, and the common electrode line in the display substrate shown in Fig. 14 may have the same characteristics as the corresponding structures shown in Fig. 4, and will not be repeated herein.

In some examples, as shown in Figs. 14 to 18, a plurality of light shielding portions 500 are provided, at least one of the light shielding portions 500 is spaced apart from the gate electrode 403 of any transistor 400, and the light shielding portion 500 is insulated from the gate line 200. By spacing the light shielding portion apart from the gate electrode to insulate the light shielding portion from the gate line, it is conducive to reducing the effect of the light shielding portion on the signal transmitted on the gate line.

In some examples, as shown in Figs. 15, 17, and 18, there is a spacing S between the light shielding portion 500 and the gate electrode 403 nearest thereto, in a direction perpendicular to the base substrate, such as a direction perpendicular to the XY plane, and at least a part of the spacing S is overlapped with the protruding portion 210.

In some examples, as shown in Fig. 17, a distance D3 between the light shielding portion 500 and the gate electrode 403 nearest thereto is in a range from 2 to 15 micrometers. For example, the distance D3 may be the dimension of the spacing S. For example, the distance D3 between the light shielding portion 500 and the gate electrode 403 nearest thereto is 5 micrometers. For example, the distance D3 between the light shielding portion 500 and the gate electrode 403 nearest thereto is in a range from 3 to 10 micrometers. For example, the distance D3 between the light shielding portion 500 and the gate electrode 403 nearest thereto is in a range from 4.5 to 6 micrometers. By setting the distance between the light shielding portion and the gate nearest thereto, it is possible to avoid a short circuit between the light shielding portion and the gate electrode while shielding the semiconductor portion by the light shielding portion.

In some examples, as shown in Figs. 17 and 18, the spacing S is provided between the at least one light shielding portion 500 and the gate electrode 403 nearest thereto, a portion of the gate electrode 403 that is away from the gate line main body 220 electrically connected thereto protrudes toward the light shielding portion 500, and the gate electrode 403 and the corresponding light shielding portion 500 are complementary in shape. For example, the gate electrode 403 includes a first portion overlapped with the active layer 404 and a second portion electrically connected to the gate line 200. The second portion is located between the first portion and the light shielding portion 500, and the dimension of the first portion in the Y direction is greater than the dimension of the second portion in the Y direction.

For example, as shown in Figs. 17 and 18, in the direction indicated by an arrow in the Y direction, the dimension of the gate electrode 403 in the X direction is gradually increased, and the dimension of the light shielding portion 500 in the X direction is gradually decreased to realize that an edge of the gate electrode that is close to the light shielding portion and an edge of the light shielding portion that is close to the gate electrode are substantially parallel to each other, and to increase the utilization rate of the space while shading the semiconductor portion by the light shielding portion.

For example, as shown in Fig. 17, an edge of the gate electrode 403 on a side away from the gate line and extending in the X direction and an edge of the light shielding portion 500 on a side away from the gate line and extending in the X direction are substantially in a straight line to prevent the light shielding portion from being close to the pixel electrode.

For example, as shown in Fig. 17, the conductive portion laminated with the light shielding portion 500 and the conductive portion laminated with the gate electrode 403 are insulated to avoid an electric connection between the light shielding portion and the gate electrode. For example, the distance between the conductive portion laminated with the light shielding portion 500 and the conductive portion laminated with the gate electrode 403 is less than the distance between the light shielding portion 500 and the gate electrode 403. For example, an edge of the conductive portion laminated with the light shielding portion 500 and an edge of the conductive portion laminated with the gate electrode 403 that are close to each other are provided in parallel.

For example, as shown in Fig. 17, a distance D4 between the conductive portion laminated with the light shielding portion 500 and the conductive portion laminated with the gate electrode 403 is greater than 0 and not greater than 15 micrometers. For example, the distance D4 between the conductive portion laminated with the light shielding portion 500 and the conductive portion laminated with the gate electrode 403 may be 1 micrometer. For example, the distance D4 between the conductive portion laminated with the light shielding portion 500 and the conductive portion laminated with the gate electrode 403 may be in a range from 1.2 to 5 micrometers. For example, the distance D4 between the conductive portion laminated with the light shielding portion 500 and the conductive portion laminated with the gate electrode 403 may be in a range from 1.5 to 3 micrometers. For example, the distance D4 between the conductive portion laminated with the light shielding portion 500 and the conductive portion laminated with the gate electrode 403 may be in a range from 2 to 7 micrometers.

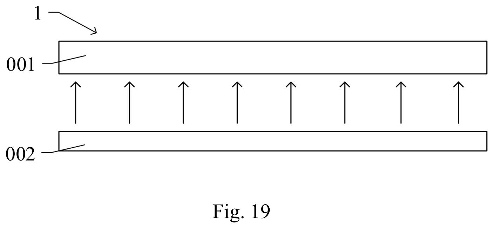

Fig. 19 is a schematic diagram of a partial structure of a display apparatus according to an embodiment of the present disclosure.

As shown in Fig. 19, another embodiment of the present disclosure provides a display apparatus 1, which includes the display substrate 001 in any of the above examples.

In some examples, as shown in Fig. 19, the display apparatus further includes a backlight 002. The backlight 002 is located on the light incident side of the display substrate 001. The backlight 002 includes a pulse width modulation backlight.

For example, the display apparatus may be a liquid crystal display apparatus. For example, the display substrate described above may be an array substrate, and the display apparatus further includes an opposing substrate disposed opposite the display substrate. For example, the opposing substrate may include a black matrix and a color film layer. For example, the display apparatus may further include a liquid crystal layer located between the array substrate and the opposing substrate.

For example, the display apparatus may be any product or component having a display function, for example, a mobile phone, a tablet computer, a notebook computer, or a navigator. This embodiment is not limited thereto.

The following statements should be noted:
(1) The accompanying drawings involve only the structure(s) in connection with the embodiment(s) of the present disclosure, and other structure(s) can be referred to common design(s).
(2) In case of no conflict, features in one embodiment or in different embodiments can be combined.

What have been described above are only specific implementations of the present disclosure, the protection scope of the present disclosure is not limited thereto. The protection scope of the present disclosure should be based on the protection scope of the claims.

## Claims

1. A display substrate, comprising:
a base substrate;
a plurality of data lines, located on the base substrate, the plurality of data lines being arranged along a first direction;
a plurality of gate lines, located on the base substrate, the plurality of gate lines being arranged along a second direction, the second direction intersecting the first direction;
a semiconductor layer, laminated with a film layer where the plurality of gate lines are located, and located between the film layer where the plurality of gate lines are located and a film layer where the plurality of data lines are located;
a plurality of transistors, disposed on the base substrate, each transistor of the plurality of transistors comprising a gate electrode, an active layer, a first electrode, and a second electrode, the gate electrode being electrically connected to a gate line of the plurality of gate lines, the first electrode being electrically connected to a data line of the plurality of data lines, the semiconductor layer comprising the active layer, and in a direction perpendicular to the base substrate, the gate electrode, the first electrode, and the second electrode all being overlapped with the active layer;
wherein the plurality of gate lines are located on a side of the plurality of data lines that is away from the base substrate, the gate electrode is disposed in the same layer as the plurality of data lines, the semiconductor layer comprises a semiconductor portion laminated with the plurality of gate lines, and the semiconductor portion is spaced apart from the active layer, and
the display substrate further comprises a light shielding portion, disposed in the same layer as the plurality of data lines, and in the direction perpendicular to the base substrate, at least a part of the semiconductor portion is overlapped with the light shielding portion.

2. The display substrate according to claim 1, wherein at least one gate line comprises a protruding portion and a gate line main body connected to each other, a straight line extending in the first direction passes through orthographic projections of the gate electrode and the protruding portion on the base substrate, the semiconductor portion comprises a first semiconductor portion laminated with the protruding portion and a second semiconductor portion laminated with the gate line main body, and more than 80% of an area of an orthographic projection of the first semiconductor portion on the base substrate falls within an orthographic projection of the light shielding portion on the base substrate.

3. The display substrate according to claim 2, wherein at least a part of an edge of the light shielding portion is further away from the second semiconductor portion than an edge of the first semiconductor portion, and the orthographic projection of the first semiconductor portion on the base substrate is located completely within orthographic projections of the light shielding portion and gate electrode on the base substrate.

4. The display substrate according to claim 2 or 3, wherein, in the direction perpendicular to the base substrate, a part of the second semiconductor portion is overlapped with the light shielding portion.

5. The display substrate according to claim 4, wherein more than 70% of an area of an orthographic projection, on the base substrate, of the second semiconductor portion that is laminated with a portion, of the at least one gate line, located between two adjacent data lines falls within the orthographic projection of the light shielding portion on the base substrate.

6. The display substrate according to claim 2, wherein a plurality of light shielding portions are provided, and at least one light shielding portion and the gate electrode of at least one transistor are of an integrated structure.

7. The display substrate according to claim 6, wherein a dimension of an overlap between the integrated structure and the gate line main body in the first direction is greater than a dimension of an overlap between the integrated structure and the protruding portion in the first direction.

8. The display substrate according to claim 2, wherein a plurality of light shielding portions are provided, at least one light shielding portion is spaced apart from the gate electrode of any transistor, and the light shielding portion is insulated from the gate line.

9. The display substrate according to claim 8, wherein a spacing is provided between the light shielding portion and the gate electrode nearest to the light shielding portion, and in the direction perpendicular to the base substrate, at least a part of the spacing is overlapped with the protruding portion.

10. The display substrate according to claim 8, wherein a spacing is provided between the at least one light shielding portion and the gate electrode nearest to the light shielding portion, a portion of the gate electrode that is away from the gate line main body electrically connected to the gate electrode protrudes toward the light shielding portion, and the gate electrode and a corresponding light shielding portion are complementary in shape.

11. The display substrate according to any one of claims 2-10, wherein the light shielding portion comprises a first light shielding portion overlapped with the first semiconductor portion and a second light shielding portion overlapped with the second semiconductor portion, and an edge of the second light shielding portion is closer to a data line of the plurality of data lines relative to an edge of the first light shielding portion.

12. The display substrate according to claim 2, wherein, in the direction perpendicular to the base substrate, the gate line main body is not overlapped with the gate electrode, and the gate electrode is electrically connected to the protruding portion.

13. The display substrate according to any one of claims 1-12, wherein a distance between the light shielding portion and a data line nearest to the light shielding portion is in a range from 2 to 15 micrometers.

14. The display substrate according to claim 8, wherein a distance between the light shielding portion and the gate electrode nearest to the light shielding portion is in a range from 2 to 15 micrometers.

15. The display substrate according to any one of claims 1-14, wherein a dimension of a part of the light shielding portion that extends beyond an edge of the semiconductor portion overlapped therewith is greater than 1.65 micrometers and less than 5 micrometers.

16. The display substrate according to any one of claims 1-15, wherein the film layer where the plurality of gate lines are located is in direct contact with the semiconductor layer.

17. The display substrate according to any one of claims 2-12, further comprising:
a first electrode layer, located between the plurality of data lines and the base substrate, and
a second electrode layer, located on a side of the plurality of gate lines that is away from the data lines,
wherein the first electrode layer comprises a pixel electrode, the pixel electrode is electrically connected to the second electrode of the transistor, the second electrode layer comprises a common electrode, the first electrode layer further comprises a conductive portion, at least a part of the conductive portion is laminated with and in direct contact with the plurality of data lines, the second electrode layer further comprises a plurality of connecting portions, and the gate electrode is electrically connected to the protruding portion through at least one connecting portion.

18. A display apparatus, comprising the display substrate according to any one of claims 1-17.

19. The display apparatus according to claim 18, further comprising:
a backlight, located on a light incident side of the display substrate,
wherein the backlight comprises a pulse width modulation backlight.
